# EUROPEAN PATENT SPECIFICATION

(11) **EP 4 116 661 B1**
(45) Date of publication and mention of the grant of the patent: **10.09.2025**
(21) Application number: 22184069.7
(22) Date of filing: 11.07.2022
(51) Int. Cl.: F28F 3/12, F28F 7/02, H05K 7/20

(54) **MONOLITHIC REDUNDANT LOOP COLD PLATE CORE UTILIZING ADJACENT THERMAL FEATURES**
MONOLITHISCHER REDUNDANTER KÜHLPLATTENKERN UNTER VERWENDUNG VON BENACHBARTEN THERMISCHEN MERKMALEN
NOYAU DE PLAQUE FROIDE À BOUCLE REDONDANTE MONOLITHIQUE UTILISANT DES CARACTÉRISTIQUES THERMIQUES ADJACENTES

(30) Priority: 09.07.2021 US 202117371758
(43) Date of publication of application: 11.01.2023
(73) Proprietor: Hamilton Sundstrand Corporation, Charlotte, NC 28217-4578 (US)
(72) Inventor: ZAFFETTI, Mark A., Suffield, 06078 (US); STRANGE, Jeremy M., Windsor, 06095 (US); RUIZ, Gabriel, Broad Brook, CT, 06016 (US)
(74) Representative: Dehns

(56) References cited:
- EP-A1- 3 124 906
- EP-A1- 3 587 989
- EP-A1- 3 800 417

## Description

### BACKGROUND

The subject matter disclosed herein relates generally to the field of heat transfer devices, and specifically to redundant heat transfer systems.

Redundant cooling loops are typically required for critical heat removal applications in vehicles so that if a failure were to occur in a first cooling loop then the vehicle would still be able to function using a second cooling loop. Current redundant cooling loops utilize two stacked cooling layers, which stack a first cooling loop on top of a second cooling loop with the first cooling loop being closest to the heat source.

### BRIEF SUMMARY

According to one aspect, a monolithic redundant loop cold plate core is provided as defined by claim 1.

In embodiments may include that the monolithic redundant loop cold plate core is a monolithic structure formed via an additive manufacturing technique.

In embodiments may include that the additive manufacturing technique is laser powder bed fusion additive manufacturing.

In embodiments may include that the one or more first cooling loop passageways include two first cooling loop passageways and the one or more second cooling loop passageways include one second cooling loop passageway. The one second cooling loop passageway is located between the two first cooling loop passageways.

In embodiments may include that the one or more first cooling loop passageways include one first cooling loop passageways and the one or more second cooling loop passageways include two second cooling loop passageway. The one first cooling loop passageway is located between the two second cooling loop passageways.

In embodiments may include fin walls formed within the core structure. The fin walls define the one or more first cooling loop passageways and the one or more second cooling loop passageways. The fin walls fluidly separate the one or more first cooling loop passageways from the one or more second cooling loop passageways.

In embodiments may include that the one or more first cooling loop passageways and the one or more second cooling loop passageways follow a non-linear pattern across the heat exchanger core.

In embodiments may include that the non-linear pattern includes at least one of a radius of the non-linear pattern, a pitch length of the non-linear pattern, or a peak-to-peak height of the non-linear pattern.

In embodiments may include that the one or more passes further include a second pass, a third pass, a first one-eighty turn connecting the first pass to the second pass, and a second one-eighty turn connecting the second pass to the third pass.

In embodiments may include that the one or more first cooling loop passageways and the one or more second cooling loop passageways follow a non-linear pattern across the heat exchanger core through the first pass, the first one-eighty turn, the second pass, the second one-eighty turn, and the third pass.

According to another aspect, a method of manufacturing a monolithic redundant loop cold plate core is provided as defined by claim 8.

In embodiments may include that the additive manufacturing technique is laser powder bed fusion additive manufacturing.

In embodiments may include that the monolithic redundant loop cold plate core is a monolithic structure formed by the additive manufacturing technique.

In embodiments may include that the one or more first cooling loop passageways include two first cooling loop passageways and the one or more second cooling loop passageways include one second cooling loop passageway. The one second cooling loop passageway is located between the two first cooling loop passageways.

In embodiments may include that the one or more first cooling loop passageways include one first cooling loop passageways and the one or more second cooling loop passageways include two second cooling loop passageway. The one first cooling loop passageway is located between the two second cooling loop passageways.

In embodiments may include forming, using the additive manufacturing technique, fin walls within the core structure. The fin walls define the one or more first cooling loop passageways and the one or more second cooling loop passageways. The fin walls fluidly separate the one or more first cooling loop passageways from the one or more second cooling loop passageways.

In embodiments may include that the one or more first cooling loop passageways and the one or more second cooling loop passageways follow a non-linear pattern across the heat exchanger core.

In embodiments may include that the non-linear pattern includes at least one of a radius of the non-linear pattern, a pitch length of the non-linear pattern, or a peak-to-peak height of the non-linear pattern.

In embodiments may include that the one or more passes further include a second pass, a third pass, a first one-eighty turn connecting the first pass to the second pass, and a second one-eighty turn connecting the second pass to the third pass.

In embodiments may include that the one or more first cooling loop passageways and the one or more second cooling loop passageways follow a non-linear pattern across the heat exchanger core through the first pass, the first one-eighty turn, the second pass, the second one-eighty turn, and the third pass.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION

The following descriptions should not be considered limiting in any way. With reference to the accompanying drawings, like elements are numbered alike:
FIG. 1 illustrates a first or top cross sectional view of a monolithic redundant loop cold plate core, according to an embodiment of the present disclosure;
FIG. 2 illustrates a second or bottom cross sectional view of the monolithic redundant loop cold plate core, according to an embodiment of the present disclosure;
FIG. 3 illustrates an enlarged view of cooling loop passageways for a first cooling loop and a second cooling loop of the monolithic redundant loop cold plate core, in accordance with an embodiment of the present disclosure;
FIG. 4 illustrates a cross-sectional view a first pass of the monolithic redundant loop cold plate core, in accordance with an embodiment of the present disclosure;
FIG. 5 illustrates an enlarged view of the cooling loop passageways transitioning from the first pass to the first one-eighty turn, in accordance with an embodiment of the present disclosure;
FIG. 6 illustrates an enlarged view of the non-linear pattern of the first cooling loop passageways, the second cooling loop passageways, and the fin walls, in accordance with an embodiment of the present disclosure;
FIG. 7 illustrates an isometric wire mesh view of the monolithic redundant loop cold plate core, in accordance with an embodiment of the present disclosure;
FIG. 8A illustrates an inlet end of a core structure of the monolithic redundant loop cold plate core, in accordance with an embodiment of the present disclosure;
FIG. 8B illustrates an outlet end of the core structure of the monolithic redundant loop cold plate core, in accordance with an embodiment of the present disclosure; and
FIG. 9 illustrates a flow chart of a method of manufacturing the monolithic redundant loop cold plate core, in accordance with an embodiment of the present disclosure.

### DETAILED DESCRIPTION

A detailed description of one or more embodiments of the disclosed apparatus and method are presented herein by way of exemplification and not limitation with reference to the Figures.

As previously noted, redundant cooling loops are typically required for critical heat removal applications in vehicles so that if a failure were to occur in a first cooling loop then the vehicle would still be able to function using a second cooling loop. As also noted, current plate and fin redundant cooling loops utilize two stacked cooling layers, which stack a first cooling loop on top of a second cooling loop with the first cooling loop being closest to the heat source. Therefore, if the first cooling loop fails then heat must travel through the failed first cooling loop to reach the second cooling loop. Embodiments disclosed herein seek to provide a second cooling loop that is side-by-side with the first cooling loop and not in a stacked arranged such that, if the first cooling loop were to fail, heat would not have to transfer through the first cooling loop to reach the second cooling loop.

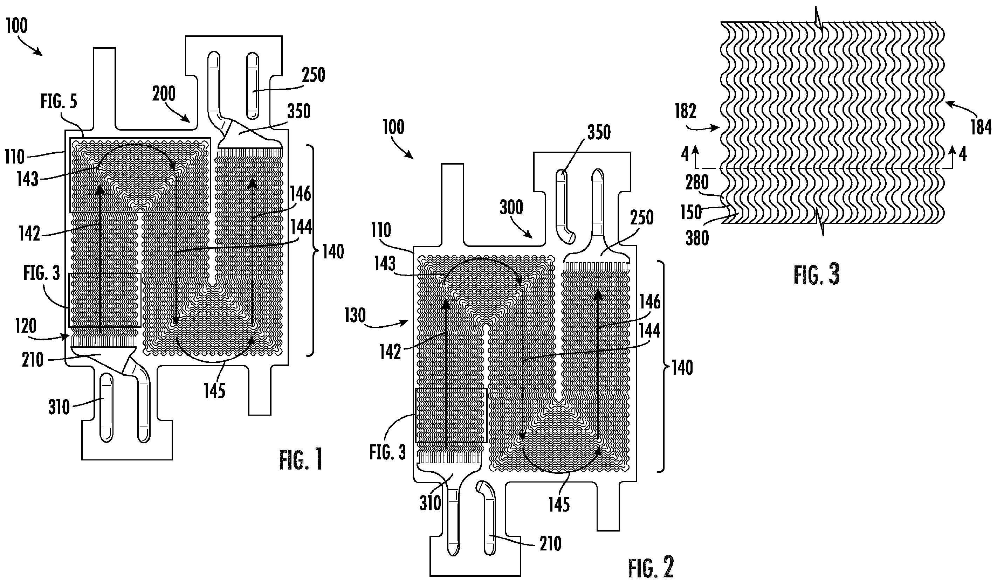

Referring now to FIGS. 1, 2, and 3, various cross-sectional views of a monolithic redundant loop cold plate core 100 are illustrated, according to an embodiment of the present disclosure. FIG. 1 illustrates a first or top view of the monolithic redundant loop cold plate core 100, FIG. 2 illustrates a second or bottom view of the monolithic redundant loop cold plate core 100, and FIG. 3 illustrates an enlarged view of cooling loop passageways 280, 380 for a first cooling loop 200 and a second cooling loop 300 of the monolithic redundant loop cold plate core 100, according to an embodiment of the present disclosure. While the exemplary monolithic redundant loop cold plate core 100 is illustrated as a three-pass heat exchanger for explanatory purposes, it is understood that the monolithic redundant loop cold plate core 100 may include any number of passes in alternate embodiments.

The monolithic redundant loop cold plate core 100 is a monolithic structure rather than being assembled from separate individually formed components that are then assembled. The term monolithic may be defined as an object that is cast or formed as single piece without joints or seams. In other words, the monolithic redundant loop cold plate core 100 is formed as a single piece comprising a unitary structure. In an embodiment, the monolithic redundant loop cold plate core 100 has no joints or seams. The monolithic redundant loop cold plate core 100 may be manufactured or formed via an additive manufacturing technique known to one of skill in the art. In an embodiment, the monolithic redundant loop cold plate core 100 may be manufactured by growing the structure one layer at a time where a laser is used to fuse powder together in one monolithic structure one layer at a time. In an embodiment, the monolithic redundant loop cold plate core 100 may be manufactured by laser powder bed fusion (L-PBF) additive manufacturing.

The monolithic redundant loop cold plate core 100 includes a core structure 110 having a first portion 120 and a second portion 130. In an embodiment the first portion 120 may be an upper portion and the second portion 130 may be a lower portion or vice-versa depending on which way the monolithic redundant loop cold plate core 100 is gravitationally oriented. The core structure 110 includes a first cooling loop 200 formed within the core 100 and a second cooling loop 300 formed within the core structure 110.

The first cooling loop 200 is configured to convey a first coolant through the monolithic redundant loop cold plate core 100. In an embodiment, the first coolant may be air or a mixture of water and propylene glycol (PGW). The first cooling loop 200 includes a first cooling loop inlet manifold 210 and a first cooling loop outlet manifold 250. The first cooling loop inlet manifold 210 may be located in the first portion 120 and the first cooling loop outlet manifold 250 may be located in the second portion 130. The first cooling loop outlet manifold 250 is fluidly connected to the first cooling loop inlet manifold 210 through one or more first cooling loop passageways 280. The one or more first cooling loop passageways 280 extend across a heat exchanger core 140. The first cooling loop inlet manifold 210 is fluidly connected to the one or more first cooling loop passageways 280. The first cooling loop inlet manifold 210 is configured to divide the first coolant into the one or more first cooling loop passageways 280. The first cooling loop outlet manifold 250 is fluidly connected to the one or more first cooling loop passageways 280. The first cooling loop outlet manifold 250 is configured to combine the first coolant from the one or more first cooling loop passageways 280.

In an embodiment, the one or more first cooling loop passageways 280 make three passes across the heat exchanger core 140, which include a first pass 142, a second pass 144, and a third pass 146. It is understood that while three passes 142, 144, 146 are illustrated, the embodiments described herein may be applicable to the one or more first cooling loop passageways 280 making any number of passes across the heat exchanger core 140. The one or more first cooling loop passageways 280 may make a first one-eighty turn 143 connecting the first pass 142 to the second pass 144. The first one-eighty turn 143 turns the one or more first cooling loop passageways 280 one hundred and eighty degrees. Further, the one or more first cooling loop passageways 280 may make a second one-eighty turn 145 connecting the second pass 144 to the third pass 146. The second one-eighty turn 145 turns the one or more first cooling loop passageways 280 one hundred and eighty degrees. In an embodiment, the third pass 146 may be about parallel to the first pass 142 and the second pass 144.

The one or more first cooling loop passageways 280 may follow a non-linear pattern across the heat exchanger core 140 as shown in the enlarged view of FIG. 3. In an embodiment the non-linear pattern may be a wave pattern. The fin walls 150 may define the non-linear pattern. Advantageously, the non-linear pattern of the one or more first cooling loop passageways 280 helps create more surface area for increased heat transfer between the first coolant and the core structure 110, as opposed to straight or linear cooling loop passageways. Also, advantageously, the non-linear pattern of the one or more first cooling loop passageways 280 helps generate turbulence within the one or more first cooling loop passageways 280 for increased heat transfer between the first coolant and the core structure 110, as opposed to straight or linear cooling loop passageways. The one or more first cooling loop passageways 280 may follow the non-linear pattern across an entire length of the one or more first cooling loop passageways 280 from the first cooling loop inlet manifold 210 to the first cooling loop outlet manifold 250. The one or more first cooling loop passageways 280 may follow the non-linear pattern across through the first pass 142, the first one-eighty turn 143, the second pass 144, the second one-eighty turn 145, and the third pass 146.

The second cooling loop 300 is configured to convey a second coolant through the monolithic redundant loop cold plate core 100. The second coolant is fluidly separated from the first coolant but may be the same coolant as the first coolant. In an embodiment, second coolant may be air or a mixture of water and PGW. The second cooling loop 300 includes a second cooling loop inlet manifold 310 and a second cooling loop outlet manifold 350. The second cooling loop inlet manifold 310 may be located in the second portion 130 and the second cooling loop outlet manifold 350 may be located in the first portion 120. The second cooling loop outlet manifold 350 is fluidly connected to the second cooling loop inlet manifold 310 through one or more second cooling loop passageways 380. The one or more second cooling loop passageways 380 extend across the heat exchanger core 140. The second cooling loop inlet manifold 310 is fluidly connected to the one or more second cooling loop passageways 380. The second cooling loop inlet manifold 310 is configured to divide the second coolant into the one or more second cooling loop passageways 380. The second cooling loop outlet manifold 350 is fluidly connected to the one or more second cooling loop passageways 380. The second cooling loop outlet manifold 350 is configured to combine the second coolant from the one or more second cooling loop passageways 380.

In an embodiment, the one or more second cooling loop passageways 380 make three passes across the heat exchanger core 140, which include a first pass 142, a second pass 144, and a third pass 146. It is understood that while three passes 142, 144, 146 are illustrated, the embodiments described herein may be applicable to the one or more second cooling loop passageways 380 making any number of passes across the heat exchanger core 140. The one or more second cooling loop passageways 380 may make a first one-eighty turn 143 connecting the first pass 142 to the second pass 144. The first one-eighty turn 143 turns the one or more second cooling loop passageways 380 one hundred and eighty degrees. Further, the one or more second cooling loop passageways 380 may make a second one-eighty turn 145 connecting the second pass 144 to the third pass 146. The second one-eighty turn 145 turns the one or more second cooling loop passageways 380 one hundred and eighty degrees. In an embodiment, the third pass 146 may be about parallel to the first pass 142 and the second pass 144.

The one or more second cooling loop passageways 380 may follow a non-linear pattern as shown in the enlarged view of FIG. 3. In an embodiment, the non-linear pattern may be a wave pattern. The fin walls 150 may define the non-linear pattern. Advantageously, the non-linear pattern of the one or more second cooling loop passageways 380 helps create more surface area for increased heat transfer between the second coolant and the core structure 110, as opposed to straight or linear cooling loop passageways. Also, advantageously, the non-linear pattern of the one or more second cooling loop passageways 380 helps generate turbulence within the one or more second cooling loop passageways 380 for increased heat transfer between the second coolant and the core structure 110, as opposed to straight or linear cooling loop passageways. The one or more second cooling loop passageways 380 may follow the non-linear pattern across an entire length of the one or more second cooling loop passageways 380 from the second cooling loop inlet manifold 310 to the second cooling loop outlet manifold 350. The one or more second cooling loop passageways 380 may follow the non-linear pattern across through the first pass 142, the first one-eighty turn 143, the second pass 144, the second one-eighty turn 145, and the third pass 146.

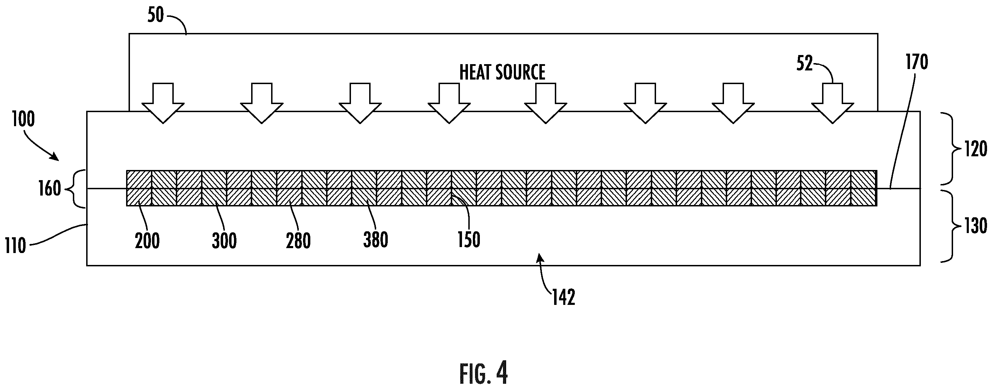

As illustrated in FIG. 3, the one or more first cooling loop passageways 280 are intermixed in an alternating side-by-side arrangement with the one or more second cooling loop passageways 380 in a single cooling plane (see FIG. 4). The one or more first cooling loop passageways 280 alternate with the one or more second cooling loop passageways 380 going from a first side 182 of the first pass 142 to a second side 184 of the first pass 142.

There may be at least one second cooling loop passageway 380 between each two first cooling loop passageways 280. For example, there may be at least two first cooling loop passageways 280 and at least one second cooling loop passageway 380 and the one second cooling loop passageways 380 is located between the two first cooling loop passageway 280.

There may be at least one first cooling loop passageway 280 between each two second cooling loop passageways 380. For example, there may be at least two second cooling loop passageways 380 and at least one first cooling loop passageway 280 and the one first cooling loop passageways 280 is located between the two second cooling loop passageway 380. In an embodiment, there are an equal number of first cooling loop passageways 280 and second cooling loop passageways 380.

Fin walls 150 may be formed within the core structure 110. The fin walls 150 may define each of the first cooling loop passageways 280 and each of the second cooling loop passageways 380 within the core structure 110.

Each of the one or more first cooling loop passageways 280 is separated from adjacent ones of the second cooling loop passageways 380 by fin walls 150 formed in the core structure 110. The fin walls 150 fluidly separate the first cooling loop passageways 280 from the second cooling loop passageways 380. The one or more first cooling loop passageways 280 flow about parallel with the one or more second cooling loop passageways 380 through the first pass 142, the first one-eighty turn 143, the second pass 144, the second one-eighty turn 145, and the third pass 146.

Referring now to FIG. 4, a cross-sectional view a first pass 142 of the monolithic redundant loop cold plate core 100 is illustrated, according to an embodiment of the present disclosure. It is understood that the arrangement shown in FIG. 4 along the first pass 142, according to an exemplary embodiment, is also applicable to the second pass 144, the third pass 146, the first one-eighty turn 143, and the second one-eighty turn 145 of the first cooling loop 200 and the second cooling loop 300 because the single cooling plane 160 remains planar throughout the entire core structure.

Coolant within the first cooling loop 200 and the second cooling loop 300 is configured to receive heat 52 from a heat source 50 through the core structure 110. It is understood that while the heat source 50 is illustrated as being adjacent to the first portion 120 for explanatory purposes, the heat source 50 may be adjacent to the second portion 130 according to alternate embodiments. It is also understood that there may be more than one heat source 50. The heat source 50 may be oriented about parallel to the single cooling plane 160, as illustrated in FIG. 4.

As shown in FIG. 4, the one or more first cooling loop passageways 280 are intermixed between the one or more second cooling loop passageways 380 in a single cooling plane 160, which allows each of the first cooling loop 200 and the second cooling loop 300 to receive an equal amount of heat 52 from a heat source 50. Advantageously, the heat 52 does not need to pass through the first cooling loop 200 to get to the second cooling loop 300. Also, advantageously, the heat 52 does not need to pass through the second cooling loop 300 to get to the first cooling loop 200.

A central plane 170 may separate the first portion 120 of the monolithic redundant loop cold plate core 100 from the second portion 130 of the monolithic redundant loop cold plate core 100. The central plane 170 may bifurcate the core structure 110 into two equal portions, such that the first portion 120 is about equal in size to the second portion 130.

The single cooling plane 160 may run parallel to and/or along the central plane 170, as illustrated in FIG. 4. The one or more first cooling loop passageways 280 may alternate with the one or more second cooling loop passageways 380 along the central plane 170, as illustrated in FIG. 4. Each of the one or more first cooling loop passageways 280 are separated from adjacent second cooling loop passageways 380 by the fin walls 150 formed in the core structure 110.

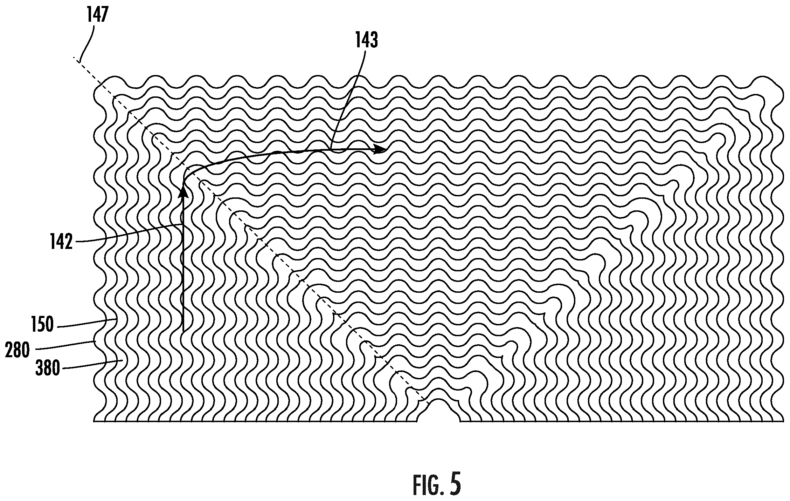

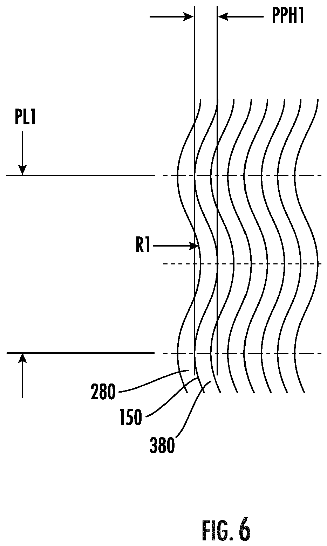

Referring now to FIG. 5, an enlarged view of the cooling loop passageways 280, 380 transitioning from the first pass 142 to the first one-eighty turn 143 is illustrated, according to an embodiment of the present disclosure. It is understood that the embodiment disclosed in FIG. 5 is also applicable to the cooling loop passageways 280, 380 transitioning from the first one-eighty turn 143 to the second pass 144, from the second pass 144 to the second one-eighty turn 145, and from the second one-eighty turn 145 to the third pass 146. As illustrated in FIG. 5, the first cooling loop passageways 280 and the second cooling loop passageways 380 maintain the non-linear pattern in the transition 147 from the first pass 142 to the first one-eighty turn 143. As illustrated in FIG. 5, the pitch length PL1 (see FIG. 6) of the first cooling loop passageways 280 and the second cooling loop passageways 380 of the non-linear pattern is also maintained in the transition 147 from the first pass 142 to the first one-eighty turn 143, which creates a unique geometry in the transition 147.

Referring now to FIG. 6, an enlarged view of the non-linear pattern of the first cooling loop passageways 280, the second cooling loop passageways 380, and the fin walls 150 is illustrated, according to an embodiment of the present disclosure. As illustrated in FIG. 6, the fin walls 150 shape the first cooling loop passageways 280 and the second cooling loop passageways 380 into the non-linear pattern. In an embodiment, the non-linear pattern may be a wave pattern or more specifically a sine wave pattern. In an embodiment, the non-linear pattern may be a herringbone pattern or a louvered pattern. As illustrated in FIG. 6, the non-linear pattern may have specific characteristics including but not limited to a radius R1 of the non-linear pattern, a pitch length PL1 of the non-linear pattern, and a peak-to-peak height PPH1 of the non-linear pattern. Each of these characteristics may affect how much turbulence is generated within the first cooling loop passageways 280 and the second cooling loop passageways 380. Each of these characteristics may also affect how much heat 52 is transferred to the first cooling loop passageways 280 and the second cooling loop passageways 380. Advantageously, each of these characteristics may be optimized to maximize heat transfer while still meeting pressure drop and manufacturing constraints. The radius R1 of the non-linear pattern, the pitch length PL1 of the non-linear pattern, and the peak-to-peak height PPH1 of the non-linear pattern may vary along the lengths of the first cooling loop passageways 280 and the second cooling loop passageways 380.

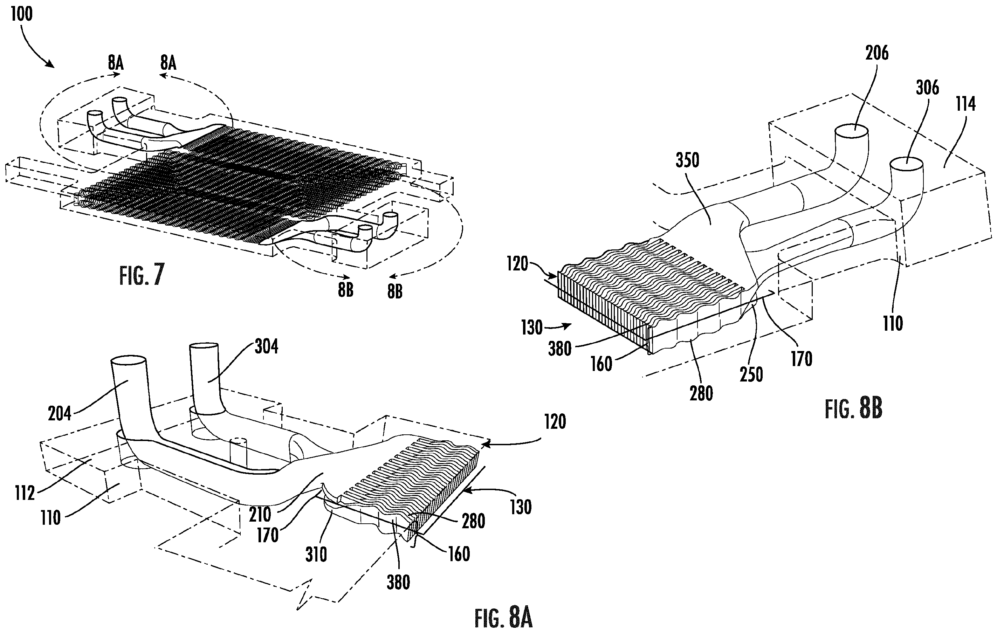

Referring now to FIGS 7, 8A, and 8B, an isometric wire mesh view of the monolithic redundant loop cold plate core 100 is illustrated in FIG. 7 to more clearly demonstrate the locations of portions detailed in FIGS. 8A and 8B, in accordance with an embodiment of the disclosure.

FIG. 8A illustrates an inlet end 112 of the core structure 110. The inlet end 112 of the core structure 110 includes the first cooling loop inlet manifold 210 and the second cooling loop inlet manifold 310. A first cooling loop inlet passageway 204 may be fluidly connected to the first cooling loop inlet manifold 210 and configured to provide the first coolant to the first cooling loop inlet manifold 210. A second cooling loop inlet passageway 304 may be fluidly connected to the second cooling loop inlet manifold 310 and configured to provide the second coolant to the second cooling loop inlet manifold 310.

The central plane 170 separates the core structure 110 into the first portion 120 and the second portion 130. As shown, the first cooling loop inlet manifold 210 is located in the first portion 120 and the second cooling loop inlet manifold 310 is located in the second portion 130. If the first portion 120 is oriented gravitationally above the second portion 130, then the first cooling loop inlet manifold 210 is located gravitationally above the second cooling loop inlet manifold 310. Advantageously, since the first cooling loop inlet manifold 210 is stacked on the second cooling loop inlet manifold 310, the one or more first cooling loop passageways 280 may weave together with the one or more second cooling loop passageways 380, such that the one or more first cooling loop passageways 280 are intermixed in an alternating side-by-side arrangement with the one or more second cooling loop passageways 380 in a single cooling plane 160.

FIG. 8B illustrates an outlet end 114 of the core structure 110. The outlet end 114 of the core structure 110 includes the first cooling loop outlet manifold 250 and the second cooling loop outlet manifold 350. A first cooling loop outlet passageway 206 may be fluidly connected to the first cooling loop outlet manifold 250 and configured to receive the first coolant from the first cooling loop outlet manifold 250. A second cooling loop outlet passageway 306 may be fluidly connected to the second cooling loop outlet manifold 350 and configured to receive the second coolant from the second cooling loop outlet manifold 350.

The central plane 170 separates the core structure 110 into the first portion 120 and the second portion 130. As shown, the first cooling loop outlet manifold 250 is located in the second portion 130 and the second cooling loop outlet manifold 350 is located in the first portion 120. If the first portion 120 is oriented gravitationally above the second portion 130, then the second cooling loop outlet manifold 350 is located gravitationally above the first cooling loop outlet manifold 250. Advantageously, since the second cooling loop outlet manifold 350 is stacked on the first cooling loop outlet manifold 250, the one or more second cooling loop passageways 380 may weave together with the one or more first cooling loop passageways 280, such that the one or more first cooling loop passageways 280 are intermixed in an alternating side-by-side arrangement with the one or more second cooling loop passageways 380 in the single cooling plane 160.

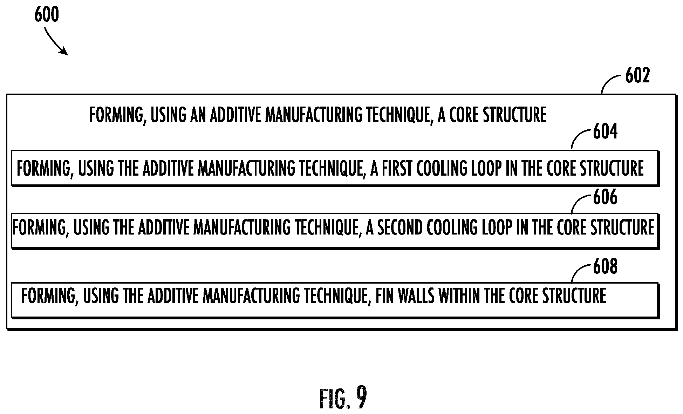

Referring now to FIG. 9, with continued reference to FIGS. 1 - 7, 8A, and 8B, a flow chart of a method 600 of manufacturing the monolithic redundant loop cold plate core 100 is illustrated, in accordance with an embodiment of the disclosure.

At block 602, a core structure 110 is formed using an additive manufacturing technique. In an embodiment, the additive manufacturing technique discussed throughout method 600 is laser powder bed fusion additive manufacturing. Block 602 includes block 604, block 606, and block 608.

At block 604, a first cooling loop 200 in the core structure 110 is formed using the additive manufacturing technique. The first cooling loop 200 including one or more first cooling loop passageways 280 extending across a heat exchanger core 140 in one or more passes. The one or more passes comprise at least a first pass 142.

At block 606, a second cooling loop 300 is formed in the core structure 110 using additive manufacturing technique. The second cooling loop 300 including one or more second cooling loop passageways 380 extending across the heat exchanger core 140 in the one or more passes.

**In** an embodiment, the one or more first cooling loop passageways 280 are intermixed in an alternating side-by-side arrangement with the one or more second cooling loop passageways 380 in a single cooling plane 160. In an embodiment, the monolithic redundant loop cold plate core 100 is a single piece comprising a unitary structure.

At block 608, fin walls 150 are formed in the core structure 110 using the additive manufacturing technique. The fin walls 150 define the one or more first cooling loop passageways 280 and fluidly separate the first cooling loop passageways 280 from the one or more second cooling loop passageways 380. The fin walls 150 define the one or more second cooling loop passageways 380 and fluidly separate the second cooling loop passageways 380 from the one or more first cooling loop passageways 280.

While the above description has described the flow process of FIG. 9 in a particular order, it should be appreciated that unless otherwise specifically required in the attached claims that the ordering of the steps may be varied and the order of the steps may occur simultaneously or near simultaneously, such as in layers.

Technical effects and benefits of the features described herein include forming a monolithic redundant loop cold plate core through additive manufacturing.

A detailed description of one or more embodiments of the disclosed apparatus and method are presented herein by way of exemplification and not limitation with reference to the Figures.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made without departing from the scope of the invention as defined by the claims. In addition, many modifications may be made to adapt a particular situation or material to the teachings of the present disclosure without departing from the scope of the claims. Therefore, it is intended that the present disclosure not be limited to the particular embodiment disclosed as the best mode contemplated for carrying out this present disclosure, but that the present disclosure will include all embodiments falling within the scope of the claims.

## Claims

1. A monolithic redundant loop cold plate core, comprising:
a plate core structure (110) having an upper portion (120) and a lower portion (130), the upper portion (120) comprising a first cooling loop inlet manifold (210) at an inlet end (112) and a second cooling loop outlet manifold (350) at an outlet end (114), and the lower portion (130) comprising a second cooling loop inlet manifold (310) at the inlet end (112) and a first cooling loop outlet manifold (250) at the outlet end (114);
a first cooling loop (200) formed in the core structure, the first cooling loop comprising one or more first cooling loop passageways (280) extending across a heat exchanger core (100) in one or more passes, wherein the one or more passes comprise at least a first pass;
a second cooling loop (300) formed in the core structure, the second cooling loop comprising one or more second cooling loop passageways (380) extending across the heat exchanger core in the one or more passes,
wherein the one or more first cooling loop passageways are intermixed in an alternating side-by-side arrangement with the one or more second cooling loop passageways in a single cooling plane, and
wherein the first cooling loop outlet manifold (250) is fluidly connected to the first cooling loop inlet manifold (210) through the first cooling loop passageways (280), and the second cooling loop outlet manifold (350) is fluidly connected to the second cooling loop inlet manifold (310) through the second cooling loop passageways (380); and
wherein the monolithic redundant loop cold plate core is a single piece comprising a unitary structure without joints or seams.

2. The monolithic redundant loop cold plate core of claim 1, wherein the monolithic redundant loop cold plate core is a monolithic structure formed via an additive manufacturing technique, and optionally wherein the additive manufacturing technique is laser powder bed fusion additive manufacturing.

3. The monolithic redundant loop cold plate core of claim 1 or 2, wherein the one or more first cooling loop passageways comprise two first cooling loop passageways and the one or more second cooling loop passageways comprise one second cooling loop passageway, and wherein the one second cooling loop passageway is located between the two first cooling loop passageways; or
wherein the one or more first cooling loop passageways comprise one first cooling loop passageways and the one or more second cooling loop passageways comprise two second cooling loop passageway, and wherein the one first cooling loop passageway is located between the two second cooling loop passageways.

4. The monolithic redundant loop cold plate core of any preceding claim, further comprising:
fin walls (150) formed within the core structure,
wherein the fin walls define the one or more first cooling loop passageways and the one or more second cooling loop passageways, and
wherein the fin walls fluidly separate the one or more first cooling loop passageways from the one or more second cooling loop passageways.

5. The monolithic redundant loop cold plate core of any preceding claim, wherein the one or more first cooling loop passageways and the one or more second cooling loop passageways follow a non-linear pattern across the heat exchanger core, and optionally wherein the non-linear pattern comprises at least one of a radius of the non-linear pattern, a pitch length of the non-linear pattern, or a peak-to-peak height of the non-linear pattern.

6. The monolithic redundant loop cold plate core of any preceding claim, wherein the one or more passes further comprise a second pass, a third pass, a first one-eighty turn connecting the first pass to the second pass, and a second one-eighty turn connecting the second pass to the third pass.

7. The monolithic redundant loop cold plate core of claim 6, wherein the one or more first cooling loop passageways and the one or more second cooling loop passageways follow a non-linear pattern across the heat exchanger core through the first pass, the first one-eighty turn, the second pass, the second one-eighty turn, and the third pass.

8. A method of manufacturing a monolithic redundant loop cold plate core as defined in claim 1, the method comprising:
forming, using an additive manufacturing technique, a plate core structure (110), the forming comprising:
forming, using the additive manufacturing technique, a first cooling loop (200) in the core structure, the first cooling loop comprising one or more first cooling loop passageways (280) extending across a heat exchanger core in one or more passes, wherein the one or more passes comprise at least a first pass; and
forming, using the additive manufacturing technique, a second cooling loop (300) in the core structure, the second cooling loop comprising one or more second cooling loop passageways (380) extending across the heat exchanger core in the one or more passes,
wherein the one or more first cooling loop passageways are intermixed in an alternating side-by-side arrangement with the one or more second cooling loop passageways in a single cooling plane, and
wherein the core structure (110) includes an upper portion (120) and a lower portion (130), the upper portion (120) comprising a first cooling loop inlet manifold (210) at an inlet end (112) and a second cooling loop outlet manifold (350) at an outlet end (114), and the lower portion (130) comprising a second cooling loop inlet manifold (310) at the inlet end (112) and a first cooling loop outlet manifold (250) at the outlet end (114); and
wherein the first cooling loop outlet manifold (250) is fluidly connected to the first cooling loop inlet manifold (210) through the first cooling loop passageways (280), and the second cooling loop outlet manifold (350) is fluidly connected to the second cooling loop inlet manifold (310) through the second cooling loop passageways (380); and
wherein the monolithic redundant loop cold plate core is a single piece comprising a unitary structure without joints or seams.

9. The method of claim 8, wherein the additive manufacturing technique is laser powder bed fusion additive manufacturing.

10. The method of claim 8 or 9, wherein the monolithic redundant loop cold plate core is a monolithic structure formed by the additive manufacturing technique.

11. The method of claim 8, 9 or 10, wherein the one or more first cooling loop passageways comprise two first cooling loop passageways and the one or more second cooling loop passageways comprise one second cooling loop passageway, and wherein the one second cooling loop passageway is located between the two first cooling loop passageways; or
wherein the one or more first cooling loop passageways comprise one first cooling loop passageways and the one or more second cooling loop passageways comprise two second cooling loop passageway, and wherein the one first cooling loop passageway is located between the two second cooling loop passageways.

12. The method of any of claims 8 to 11, further comprising:
forming, using the additive manufacturing technique, fin walls (150) within the core structure,
wherein the fin walls define the one or more first cooling loop passageways and the one or more second cooling loop passageways, and
wherein the fin walls fluidly separate the one or more first cooling loop passageways from the one or more second cooling loop passageways.

13. The method of any of claim 8 to 12, wherein the one or more first cooling loop passageways and the one or more second cooling loop passageways follow a non-linear pattern across the heat exchanger core, and optionally wherein the non-linear pattern comprises at least one of a radius of the non-linear pattern, a pitch length of the non-linear pattern, or a peak-to-peak height of the non-linear pattern.

14. The method of any of claims 8 to 13, wherein the one or more passes further comprise a second pass, a third pass, a first one-eighty turn connecting the first pass to the second pass, and a second one-eighty turn connecting the second pass to the third pass.

15. The method of claim 14, wherein the one or more first cooling loop passageways and the one or more second cooling loop passageways follow a non-linear pattern across the heat exchanger core through the first pass, the first one-eighty turn, the second pass, the second one-eighty turn, and the third pass.

## Patentansprüche

1. Monolithischer redundanter Kühlplattenkern, umfassend:
eine Plattenkernstruktur (110) mit einem oberen Abschnitt (120) und einem unteren Abschnitt (130), wobei der obere Abschnitt (120) einen ersten Kühlkreislauf-Einlassverteiler (210) an einem Einlassende (112) und einen zweiten Kühlkreislauf-Auslassverteiler (350) an einem Auslassende (114) umfasst und der untere Abschnitt (130) einen zweiten Kühlkreislauf-Einlassverteiler (310) an dem Einlassende (112) und einen ersten Kühlkreislauf-Auslassverteiler (250) an dem Auslassende (114) umfasst;
einen ersten Kühlkreislauf (200), der in der Kernstruktur gebildet ist, wobei der erste Kühlkreislauf einen oder mehrere erste Kühlkreislaufkanäle (280) umfasst, die sich in einem oder mehreren Durchgängen über einen Wärmetauscherkern (100) erstrecken, wobei der eine oder die mehreren Durchgänge mindestens einen ersten Durchgang umfassen;
einen zweiten Kühlkreislauf (300), der in der Kernstruktur gebildet ist, wobei der zweite Kühlkreislauf einen oder mehrere zweite Kühlkreislaufkanäle (380) umfasst, die sich in dem einen oder den mehreren Durchgängen über den Wärmetauscherkern erstrecken,
wobei der eine oder die mehreren ersten Kühlkreislaufkanäle in einer abwechselnden Seite-an-Seite-Anordnung mit dem einen oder den mehreren zweiten Kühlkreislaufkanälen in einer einzelnen Kühlebene vermischt sind, und
wobei der erste Kühlkreislauf-Auslassverteiler (250) durch die ersten Kühlkreislaufkanäle (280) mit dem ersten Kühlkreislauf-Einlassverteiler (210) fluidverbunden ist und der zweite Kühlkreislauf-Auslassverteiler (350) durch die zweiten Kühlkreislaufkanäle (380) mit dem zweiten Kühlkreislauf-Einlassverteiler (310) fluidverbunden ist; und
wobei der monolithische redundante Kühlplattenkern ein einzelnes Stück ist, das eine einheitliche Struktur ohne Verbindungen oder Nähte aufweist.

2. Monolithischer redundanter Kühlplattenkern nach Anspruch 1, wobei der monolithische redundante Kühlplattenkern eine monolithische Struktur ist, die über eine additive Fertigungstechnik gebildet ist, und wobei die additive Fertigungstechnik optional additive Laserpulverbettschmelzfertigung ist.

3. Monolithischer redundanter Kühlplattenkern nach Anspruch 1 oder 2, wobei der eine oder die mehreren ersten Kühlkreislaufkanäle zwei erste Kühlkreislaufkanäle umfassen und der eine oder die mehreren zweiten Kühlkreislaufkanäle einen zweiten Kühlkreislaufkanal umfassen, und wobei sich der eine zweite Kühlkreislaufkanal zwischen den beiden ersten Kühlkreislaufkanälen befindet; oder
wobei der eine oder die mehreren ersten Kühlkreislaufkanäle einen ersten Kühlkreislaufkanal umfassen und der eine oder die mehreren zweiten Kühlkreislaufkanäle zwei zweite Kühlkreislaufkanäle umfassen, und wobei sich der eine erste Kühlkreislaufkanal zwischen den beiden zweiten Kühlkreislaufkanälen befindet.

4. Monolithischer redundanter Kühlplattenkern nach einem der vorhergehenden Ansprüche, ferner umfassend:
innerhalb der Kernstruktur gebildete Rippenwände (150),
wobei die Rippenwände den einen oder die mehreren ersten Kühlkreislaufkanäle und den einen oder die mehreren zweiten Kühlkreislaufkanäle definieren, und
wobei die Rippenwände den einen oder die mehreren ersten Kühlkreislaufkanäle fluidisch von dem einen oder den mehreren zweiten Kühlkreislaufkanälen trennen.

5. Monolithischer redundanter Kühlplattenkern nach einem der vorhergehenden Ansprüche, wobei der eine oder die mehreren ersten Kühlkreislaufkanäle und der eine oder die mehreren zweiten Kühlkreislaufkanäle einem nichtlinearen Muster über den Wärmetauscherkern folgen und wobei das nichtlineare Muster optional mindestens eines von einem Radius des nichtlinearen Musters, einer Teilungslänge des nichtlinearen Musters oder einer Spitze-zu-Spitze-Höhe des nichtlinearen Musters umfasst.

6. Monolithischer redundanter Kühlplattenkern nach einem der vorhergehenden Ansprüche, wobei der eine oder die mehreren Durchgänge ferner einen zweiten Durchgang, einen dritten Durchgang, eine erste 180-Grad-Drehung, die den ersten Durchgang mit dem zweiten Durchgang verbindet, und eine zweite 180-Grad-Drehung, die den zweiten Durchgang mit dem dritten Durchgang verbindet, umfassen.

7. Monolithischer redundanter Kühlplattenkern nach Anspruch 6, wobei der eine oder die mehreren ersten Kühlkreislaufkanäle und der eine oder die mehreren zweiten Kühlkreislaufkanäle einem nichtlinearen Muster über den Wärmetauscherkern durch den ersten Durchgang, die erste 180-Grad-Drehung, den zweiten Durchgang, die zweite 180-Grad-Drehung und den dritten Durchgang folgen.

8. Verfahren zum Fertigen eines monolithischen redundanten Kühlplattenkerns nach Anspruch 1, das Verfahren umfassend:
Bilden einer Plattenkernstruktur (110) unter Verwendung einer additiven Fertigungstechnik, das Bilden umfassend:
Bilden, unter Verwendung einer additiven Fertigungstechnik, eines ersten Kühlkreislaufs (200) in der Kernstruktur, wobei der erste Kühlkreislauf einen oder mehrere erste Kühlkreislaufkanäle (280) umfasst, die sich in einem oder mehreren Durchgängen über einen Wärmetauscherkern erstrecken, wobei der eine oder die mehreren Durchgänge mindestens einen ersten Durchgang umfassen; und
Bilden, unter Verwendung einer additiven Fertigungstechnik, eines zweiten Kühlkreislaufs (300) in der Kernstruktur, wobei der zweite Kühlkreislauf einen oder mehrere zweite Kühlkreislaufkanäle (380) umfasst, die sich in dem einen oder den mehreren Durchgängen über den Wärmetauscherkern erstrecken, wobei der eine oder die mehreren ersten Kühlkreislaufkanäle in einer abwechselnden Seite-an-Seite-Anordnung mit dem einen oder den mehreren zweiten Kühlkreislaufkanälen in einer einzelnen Kühlebene vermischt sind, und
wobei die Kernstruktur (110) einen oberen Abschnitt (120) und einen unteren Abschnitt (130) beinhaltet, wobei der obere Abschnitt (120) einen ersten Kühlkreislauf-Einlassverteiler (210) an einem Einlassende (112) und einen zweiten Kühlkreislauf-Auslassverteiler (350) an einem Auslassende (114) umfasst und der untere Abschnitt (130) einen zweiten Kühlkreislauf-Einlassverteiler (310) an dem Einlassende (112) und einen ersten Kühlkreislauf-Auslassverteiler (250) an dem Auslassende (114) umfasst; und
wobei der erste Kühlkreislauf-Auslassverteiler (250) durch die ersten Kühlkreislaufkanäle (280) mit dem ersten Kühlkreislauf-Einlassverteiler (210) fluidverbunden ist und der zweite Kühlkreislauf-Auslassverteiler (350) durch die zweiten Kühlkreislaufkanäle (380) mit dem zweiten Kühlkreislauf-Einlassverteiler (310) fluidverbunden ist; und
wobei der monolithische redundante Kühlplattenkern ein einzelnes Stück ist, das eine einheitliche Struktur ohne Verbindungen oder Nähte aufweist.

9. Verfahren nach Anspruch 8, wobei die additive Fertigungstechnik additive Laserpulverbettschmelzfertigung ist.

10. Verfahren nach Anspruch 8 oder 9, wobei der monolithische redundante Kühlplattenkern eine monolithische Struktur ist, die durch die additive Fertigungstechnik gebildet wird.

11. Verfahren nach Anspruch 8, 9 oder 10, wobei der eine oder die mehreren ersten Kühlkreislaufkanäle zwei erste Kühlkreislaufkanäle umfassen und der eine oder die mehreren zweiten Kühlkreislaufkanäle einen zweiten Kühlkreislaufkanal umfassen, und wobei sich der eine zweite Kühlkreislaufkanal zwischen den beiden ersten Kühlkreislaufkanälen befindet; oder wobei der eine oder die mehreren ersten Kühlkreislaufkanäle einen ersten Kühlkreislaufkanal umfassen und der eine oder die mehreren zweiten Kühlkreislaufkanäle zwei zweite Kühlkreislaufkanäle umfassen, und wobei sich der eine erste Kühlkreislaufkanal zwischen den beiden zweiten Kühlkreislaufkanälen befindet.

12. Verfahren nach einem der Ansprüche 8 bis 11, ferner umfassend:
Bilden von Rippenwänden (150) innerhalb der Kernstruktur unter Verwendung der additiven Fertigungstechnik,
wobei die Rippenwände den einen oder die mehreren ersten Kühlkreislaufkanäle und den einen oder die mehreren zweiten Kühlkreislaufkanäle definieren, und
wobei die Rippenwände den einen oder die mehreren ersten Kühlkreislaufkanäle fluidisch von dem einen oder den mehreren zweiten Kühlkreislaufkanälen trennen.

13. Verfahren nach einem der Ansprüche 8 bis 12, wobei der eine oder die mehreren ersten Kühlkreislaufkanäle und der eine oder die mehreren zweiten Kühlkreislaufkanäle einem nichtlinearen Muster über den Wärmetauscherkern folgen und wobei das nichtlineare Muster optional mindestens eines von einem Radius des nichtlinearen Musters, einer Teilungslänge des nichtlinearen Musters oder einer Spitze-zu-Spitze-Höhe des nichtlinearen Musters umfasst.

14. Verfahren nach einem der Ansprüche 8 bis 13, wobei der eine oder die mehreren Durchgänge ferner einen zweiten Durchgang, einen dritten Durchgang, eine erste 180-Grad-Drehung, die den ersten Durchgang mit dem zweiten Durchgang verbindet, und eine zweite 180-Grad-Drehung, die den zweiten Durchgang mit dem dritten Durchgang verbindet, umfassen.

15. Verfahren nach Anspruch 14, wobei der eine oder die mehreren ersten Kühlkreislaufkanäle und der eine oder die mehreren zweiten Kühlkreislaufkanäle einem nichtlinearen Muster über den Wärmetauscherkern durch den ersten Durchgang, die erste 180-Grad-Drehung, den zweiten Durchgang, die zweite 180-Grad-Drehung und den dritten Durchgang folgen.

## Revendications

1. Noyau de plaque froide à boucle redondante monolithique, comprenant :
une structure de noyau de plaque (110) ayant une partie supérieure (120) et une partie inférieure (130), la partie supérieure (120) comprenant un collecteur d'entrée de première boucle de refroidissement (210) à une extrémité d'entrée (112) et un collecteur de sortie de seconde boucle de refroidissement (350) à une extrémité de sortie (114), et la partie inférieure (130) comprenant un collecteur d'entrée de seconde boucle de refroidissement (310) à l'extrémité d'entrée (112) et un collecteur de sortie de première boucle de refroidissement (250) à l'extrémité de sortie (114) ;
une première boucle de refroidissement (200) formée dans la structure de noyau, la première boucle de refroidissement comprenant un ou plusieurs passages de première boucle de refroidissement (280) se prolongeant à travers un noyau d'échangeur de chaleur (100) en un ou plusieurs passages, dans lequel l'un ou plusieurs passages comprennent au moins un premier passage ;
une seconde boucle de refroidissement (300) formée dans la structure de noyau, la seconde boucle de refroidissement comprenant un ou plusieurs passages de seconde boucle de refroidissement (380) se prolongeant à travers le noyau de l'échangeur de chaleur dans l'un ou plusieurs passages,
dans lequel l'un ou plusieurs passages de première boucle de refroidissement sont entremêlés dans un agencement côte à côte alterné avec l'un ou plusieurs passages de seconde boucle de refroidissement dans un seul plan de refroidissement, et
dans lequel le collecteur de sortie de première boucle de refroidissement (250) est relié fluidiquement au collecteur d'entrée de première boucle de refroidissement (210) à travers les passages de première boucle de refroidissement (280), et le collecteur de sortie de seconde boucle de refroidissement (350) est relié fluidiquement au collecteur d'entrée de seconde boucle de refroidissement (310) à travers les passages de seconde boucle de refroidissement (380) ; et
dans lequel le noyau de plaque froide à boucle redondante monolithique est une pièce unique comprenant une structure unitaire sans joints ni soudures.

2. Noyau de plaque froide à boucle redondante monolithique selon la revendication 1, dans lequel le noyau de plaque froide à boucle redondante monolithique est une structure monolithique formée par une technique de fabrication additive, et éventuellement dans lequel la technique de fabrication additive est une fabrication additive par fusion sur lit de poudre laser.

3. Noyau de plaque froide à boucle redondante monolithique selon la revendication 1 ou 2, dans lequel l'un ou plusieurs passages de première boucle de refroidissement comprennent deux passages de première boucle de refroidissement et l'un ou plusieurs passages de seconde boucle de refroidissement comprennent un passage de seconde boucle de refroidissement, et dans lequel le un passage de seconde boucle de refroidissement est situé entre les deux passages de première boucle de refroidissement ; ou dans lequel l'un ou plusieurs passages de première boucle de refroidissement comprennent un passage de première boucle de refroidissement et l'un ou plusieurs passages de seconde boucle de refroidissement comprennent deux passages de seconde boucle de refroidissement, et dans lequel le un passage de première boucle de refroidissement est situé entre les deux passages de seconde boucle de refroidissement.

4. Noyau de plaque froide à boucle redondante monolithique selon une quelconque revendication précédente, comprenant également :
des parois d'ailettes (150) formées à l'intérieur de la structure de noyau,
dans lequel les parois des ailettes définissent l'un ou plusieurs passages de première boucle de refroidissement et l'un ou plusieurs passages de seconde boucle de refroidissement, et
dans lequel les parois des ailettes séparent de manière fluidique l'un ou plusieurs passages de première boucle de refroidissement de l'un ou plusieurs passages de seconde boucle de refroidissement.

5. Noyau de plaque froide à boucle redondante monolithique selon une quelconque revendication précédente, dans lequel l'un ou plusieurs passages de première boucle de refroidissement et l'un ou plusieurs passages de seconde boucle de refroidissement suivent un motif non linéaire à travers le noyau de l'échangeur de chaleur, et éventuellement dans lequel le motif non linéaire comprend au moins un d'un rayon du motif non linéaire, d'une longueur de pas du motif non linéaire ou d'une hauteur de crête à crête du motif non linéaire.

6. Noyau de plaque froide à boucle redondante monolithique selon une quelconque revendication précédente, dans lequel l'un ou plusieurs passages comprennent également un deuxième passage, un troisième passage, un premier tour à quatre-vingts degrés reliant le premier passage au deuxième passage, et un second tour à quatre-vingts degrés reliant le deuxième passage au troisième passage.

7. Noyau de plaque froide à boucle redondante monolithique selon la revendication 6, dans lequel l'un ou plusieurs passages de première boucle de refroidissement et l'un ou plusieurs passages de seconde boucle de refroidissement suivent un motif non linéaire à travers le noyau de l'échangeur de chaleur à travers le premier passage, le premier tour à quatre-vingts degrés, le deuxième passage, le second tour à quatre-vingts degrés et le troisième passage.

8. Procédé de fabrication d'un noyau de plaque froide à boucle redondante monolithique tel que défini dans la revendication 1, le procédé comprenant :
la formation, à l'aide d'une technique de fabrication additive, d'une structure de noyau de plaque (110), la formation comprenant :
la formation, à l'aide d'une technique de fabrication additive, d'une première boucle de refroidissement (200) dans la structure de noyau, la première boucle de refroidissement comprenant l'un ou plusieurs passages de première boucle de refroidissement (280) se prolongeant à travers un noyau d'échangeur de chaleur en un ou plusieurs passages, dans lequel l'un ou plusieurs passages comprennent au moins un premier passage ; et
la formation, à l'aide d'une technique de fabrication additive, d'une seconde boucle de refroidissement (300) dans la structure de noyau, la seconde boucle de refroidissement comprenant l'un ou plusieurs passages de seconde boucle de refroidissement (380) se prolongeant à travers le noyau d'échangeur de chaleur dans l'un ou plusieurs passages,
dans lequel l'un ou plusieurs passages de première boucle de refroidissement sont entremêlés dans un agencement côte à côte alterné avec l'un ou plusieurs passages de seconde boucle de refroidissement dans un seul plan de refroidissement, et
dans lequel la structure de noyau (110) inclut une partie supérieure (120) et une partie inférieure (130), la partie supérieure (120) comprenant un collecteur d'entrée de première boucle de refroidissement (210) à une extrémité d'entrée (112) et un collecteur de sortie de seconde boucle de refroidissement (350) à une extrémité de sortie (114), et la partie inférieure (130) comprenant un collecteur d'entrée de seconde boucle de refroidissement (310) à l'extrémité d'entrée (112) et un collecteur de sortie de première boucle de refroidissement (250) à l'extrémité de sortie (114) ; et
dans lequel le collecteur de sortie de première boucle de refroidissement (250) est relié fluidiquement au collecteur d'entrée de première boucle de refroidissement (210) à travers les passages de première boucle de refroidissement (280), et le collecteur de sortie de seconde boucle de refroidissement (350) est relié fluidiquement au collecteur d'entrée de seconde boucle de refroidissement (310) à travers les passages de seconde boucle de refroidissement (380) ; et
dans lequel le noyau de plaque froide à boucle redondante monolithique est une pièce unique comprenant une structure unitaire sans joints ni soudures.

9. Procédé selon la revendication 8, dans lequel la technique de fabrication additive est une fabrication additive par fusion sur lit de poudre laser.

10. Procédé selon la revendication 8 ou 9, dans lequel le noyau de plaque froide à boucle redondante monolithique est une structure monolithique formée par la technique de fabrication additive.

11. Procédé selon la revendication 8, 9 ou 10, dans lequel l'un ou plusieurs passages de première boucle de refroidissement comprennent deux passages de première boucle de refroidissement et l'un ou plusieurs passages de seconde boucle de refroidissement comprennent un passage de seconde boucle de refroidissement, et dans lequel le un passage de seconde boucle de refroidissement est situé entre les deux passages de première boucle de refroidissement ; ou
dans lequel l'un ou plusieurs passages de première boucle de refroidissement comprennent un passage de première boucle de refroidissement et l'un ou plusieurs passages de seconde boucle de refroidissement comprennent deux passages de seconde boucle de refroidissement, et dans lequel le un passage de première boucle de refroidissement est situé entre les deux passages de seconde boucle de refroidissement.

12. Procédé selon la revendication 8 à 11, comprenant également :
la formation, à l'aide de la technique de fabrication additive, de parois d'ailettes (150) à l'intérieur de la structure de noyau,
dans lequel les parois des ailettes définissent l'un ou plusieurs passages de première boucle de refroidissement et l'un ou plusieurs passages de seconde boucle de refroidissement, et
dans lequel les parois des ailettes séparent de manière fluidique l'un ou plusieurs passages de première boucle de refroidissement de l'un ou plusieurs passages de seconde boucle de refroidissement.

13. Procédé selon l'une quelconque des revendications 8 à 12, dans lequel l'un ou plusieurs passages de première boucle de refroidissement et l'un ou plusieurs passages de seconde boucle de refroidissement suivent un motif non linéaire à travers le noyau d'échangeur de chaleur, et éventuellement dans lequel le motif non linéaire comprend au moins un d'un rayon du motif non linéaire, d'une longueur de pas du motif non linéaire, ou d'une hauteur de crête à crête du motif non linéaire.

14. Procédé selon l'une quelconque des revendications 8 à 13, dans lequel l'un ou plusieurs passages comprennent également un deuxième passage, un troisième passage, un premier tour à quatre-vingts degrés reliant le premier passage au deuxième passage, et un second tour à quatre-vingts degrés reliant le deuxième passage au troisième passage.

15. Procédé selon la revendication 14, dans lequel l'un ou plusieurs passages de première boucle de refroidissement et l'un ou plusieurs passages de seconde boucle de refroidissement suivent un motif non linéaire à travers le noyau d'échangeur de chaleur à travers le premier passage, le premier tour à quatre-vingts degrés, le deuxième passage, le second tour à quatre-vingts degrés et le troisième passage.
